# FASCICULE DE BREVET EUROPEEN

(11) **EP 0 595 735 B1**
(45) Date de publication et mention de la délivrance du brevet: **02.04.1997**
(21) Numéro de dépôt: 93420415.7
(22) Date de dépôt: 25.10.1993
(51) Int. Cl.: G01P 1/02, H05K 5/00, G01R 33/02

(54) **Capteur d'une grandeur physique orientée**
Sensor für eine richtungsabhängige physikalische Grösse
Sensor for a directional physical value

(30) Priorité: 29.10.1992 FR 9213339
(43) Date de publication de la demande: 04.05.1994
(73) Titulaire: SEXTANT AVIONIQUE S.A., F-92366 Meudon la Forêt Cédex (FR)
(72) Inventeur: Gertz, Didier, F-26000 Valence (FR); Giroud, Pierre-Stéphane, F-26500 Bourg Les Valence (FR)
(74) Mandataire: de Beaumont, Michel

(56) Documents cités:
- EP-A- 0 502 222
- WO-A-92/12437
- DE-U- 9 113 744
- DE-U- 9 202 533
- GB-A- 2 178 856

## Description

La présente invention a trait à des capteurs d'une grandeur physique orientée, comprenant un détecteur en forme de microplaquette sensible à la grandeur physique selon un axe déterminé, et une carte portant des composants électroniques, contenus dans un boîtier.

Il est bien connu que la détection d'une grandeur physique orientée telle qu'une accélération ou un champ magnétique, pouvant être représentée par un vecteur mathématique, repose d'une part sur la mesure de son intensité (module du vecteur) et, d'autre part, sur la détermination de son orientation (coordonnées du vecteur).

Dans ce domaine, les récents progrès en matière de gravure de matériaux cristallins ont permis de réaliser des détecteurs miniaturisés en forme de micro-plaquettes, notamment des détecteurs d'accélération ou des détecteurs de champ magnétique, remplaçant avantageusement les systèmes électromécaniques traditionnels, plus volumineux.

En raison de contraintes technologiques, ces détecteurs ne comportent généralement qu'un seul axe de sensibilité à la grandeur physique, l'orientation de cet axe vis-à-vis du plan de la microplaquette étant en outre imposée par la technologie de fabrication.

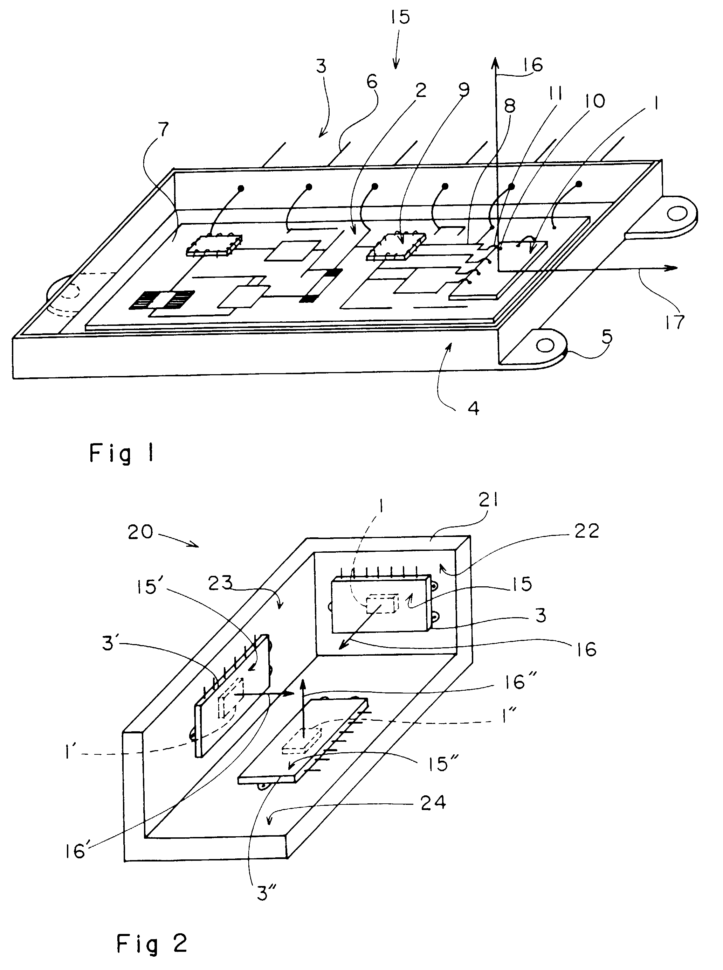

La figure 1 représente un capteur 15 classique réalisé à partir d'un détecteur miniaturisé 1, pouvant être par exemple un détecteur d'accélération ou un détecteur de champ magnétique.

Le détecteur 1, en forme de microplaquette, est associé à un circuit électronique 2 de contrôle et de commande, l'ensemble étant intégré dans un boîtier électronique 3, représenté sans capot pour faire apparaître les divers éléments. Le boîtier 3 comprend des parois latérales 4, des pattes de fixation 5, et des broches 6 pour la connexion du circuit 2 avec des éléments extérieurs. La recherche de la meilleure intégration conduisant à réaliser également le circuit 2 selon une technologie de miniaturisation, celui-ci peut être par exemple un circuit hybride, réalisé à partir d'un substrat de céramique 7 comportant des pistes conductrices 8 d'interconnexion de composants électroniques 9. Le détecteur 1 est pourvu de plots métallisés 10, connectés à des pistes 8 du circuit au moyen de fils 11, d'aluminium ou d'or, soudés par ultrasons.

Comme on l'a indiqué précédemment, le détecteur 1 ne comporte qu'un seul axe de sensibilité, dont l'orientation est en outre déterminée par la technologie de fabrication. Dans le cas d'un détecteur d'accélération, l'axe de sensibilité peut être transversal, c'est-à-dire perpendiculaire au plan de la microplaquette, ou latéral, parallèle au plan de la microplaquette. Dans le cas d'un détecteur de champ magnétique, l'axe de sensibilité est en règle générale transversal. Ces orientations sont illustrées sur la figure 1 par des axes 16 et 17.

Classiquement, et comme on peut le voir sur la figure 1, le détecteur 1 est fixé à plat dans le boîtier 3, parallèlement au substrat 7. Cette disposition est imposée par la technique de câblage ultrasonique du détecteur, qui nécessite que les plots 10 du détecteur soient parallèles aux pistes 8 du substrat. On rappelle qu'une soudure ultrasonique s'effectue au moyen d'un outil vibrant à une fréquence élevée (typiquement 60 KHz), comportant une extrémité effilée venant en appui sur le fil de câblage, à l'aplomb de la surface à souder, l'énergie de vibration transmise provoquant la soudure du fil. L'outil vibrant n'étant pas orientable, les différents points à câbler doivent être sur un même plan, ou tout au moins sur des plans sensiblement parallèles. Une autre disposition connue, équivalente, consiste à monter le détecteur 1 directement sur le fond du boîtier, à côté du substrat 7.

Ainsi, on comprend que l'orientation de l'axe de sensibilité du capteur 15, relativement au boîtier 3, ne peut pas être quelconque. Elle est imposée, d'une part, par la technologie du détecteur 1, et d'autre part, par la technique de montage et de câblage du détecteur. Selon le type de détecteur monté dans le boîtier 3, l'axe de sensibilité se trouve orienté perpendiculairement ou parallèlement au plan de fixation du boîtier 3, comme on le voit sur la figure 1.

Cela représente, dans la pratique, un inconvénient. En effet, la nécessité d'orienter l'axe de détection dans une direction donnée (la direction selon laquelle on veut mesurer la grandeur physique) conduit souvent à disposer le boîtier 3 de façon désavantageuse, et parfois de manière irrationnelle au regard des problèmes d'encombrement que cela entraîne. Cet inconvénient est particulièrement sensible lorsque le capteur est monté dans un équipement où la place est comptée.

On retrouve également cet inconvénient dans le cas de la réalisation d'un système à plusieurs axes de détection, servant à détecter une grandeur physique d'orientation quelconque. Pour illustrer ce dernier cas, on a représenté sur la figure 2 un système de mesure d'accélération triaxial 20 réalisé avec trois accéléromètres 15,15',15" comportant chacun un détecteur d'accélération 1,1',1'' ayant un axe de sensibilité transversal 16,16',16" (par analogie, on reprend ici les références de la figure 1). Pour réaliser le système triaxial 20, il a fallu monter les trois boîtiers 3,3',3" des accéléromètres 15,15',15" sur les faces respectives 22,23,24 d'un support 21 formant un trièdre de référence. On voit que cette disposition est encombrante: la longueur de chaque boîtier 3,3',3" étant typiquement d'une dizaine de centimètres, le volume occupé par le système triaxial 20 est au minimum de l'ordre du décimètre cube, soit un volume considérable pour un équipement électronique.

La présente invention vise à pallier cet inconvénient et à résoudre les problèmes qui en découlent.

Un objet de la présente invention est de prévoir un moyen permettant d'orienter de façon choisie le détecteur, relativement au boîtier, tout en conservant la possibilité de réaliser la connexion du détecteur par une technique conventionnelle, et notamment par câblage ultrasonique.

Un autre objet de la présente invention est de réaliser un capteur ayant un détecteur orientable.

Un autre objet de la présente invention est de réaliser un système à plusieurs axes de sensibilité, de faible encombrement.

Pour atteindre ces objets, la présente invention prévoit un capteur d'une grandeur physique orientée, comprenant un détecteur en forme de microplaquette, sensible à la grandeur physique selon un axe déterminé et une carte portant des composants électroniques, contenus dans un boîtier, dans lequel:
- la microplaquette est montée sur une première face d'une pièce isolante comportant une deuxième face fixée au boîtier et une troisième face s'étendant parallèlement au plan de la carte,
- des pistes conductrices s'étendent à partir de la première face, où elles sont reliées aux contacts de la microplaquette, et se prolongent sur la troisième face, et
- la carte comprend des contacts disposés sensiblement en regard des prolongements des pistes conductrices sur la troisième face.

Ainsi, grâce à l'invention, on peut choisir l'orientation du détecteur, relativement au plan de la carte, en agissant sur l'orientation relative des première et troisième faces de la pièce isolante. Comme autre avantage, les liaisons électriques entre le détecteur et les pistes sur la première face, ainsi que celles entre les pistes sur la troisième face et les contacts de la carte, peuvent être réalisées au moyen de techniques de câblage classiques, notamment par câblage ultrasonique.

Pour orienter le détecteur, on peut également agir sur l'orientation de la pièce isolante et prévoir plusieurs emplacements de fixation de la pièce isolante, la carte comprenant des contacts disposés à proximité de chaque emplacement, en regard des prolongements des pistes conductrices quand la pièce isolante est montée sur l'un de ces emplacements. On obtient de cette façon un capteur modulaire ayant un détecteur orientable, chaque emplacement correspondant à une orientation de détection donnée.

Selon une disposition préférée de la pièce isolante, celle-ci est fixée sur une paroi du boîtier, une partie au moins de la paroi s'étendant en dessous du plan de la carte, une partie de la deuxième face de la pièce isolante s'étendant éventuellement au delà de la paroi. On limite ainsi l'encombrement en hauteur de la pièce isolante, et par conséquent la hauteur nécessaire entre le plan de la carte et le capot du boîtier.

Selon un mode de réalisation de l'invention, le boîtier comprend plusieurs parois du type décrit ci-dessus, d'orientations différentes, la carte comprenant des contacts disposés au bord de chacune desdites parois, en regard des prolongements des pistes conductrices quand la pièce isolante est montée sur l'une de ces parois.

Selon un mode de réalisation avantageux de la présente invention, les parois sont des parois d'une cavité s'étendant dans une zone de boîtier, cette cavité pouvant être obtenue par évidement de la plaque de fond du boîtier.

Selon un mode de réalisation particulièrement simple de la présente invention, la cavité est parallélépipédique. En choisissant une pièce isolante également de forme parallélépipédique, la première face, sur laquelle est montée la microplaquette, étant choisie parallèle à la deuxième face, fixée au boîtier, on obtient le choix d'orienter le détecteur selon trois directions orthogonales. Pour fixer la pièce isolante, on a seulement besoin, dans ce cas, de deux parois latérales de la cavité et de la paroi formant le fond de la cavité.

La pièce isolante peut être en céramique, et peut être réalisée selon la technologie des circuits cofrittés. Dans ce cas, on peut faire des pistes conductrices s'étendant en partie dans l'intérieur de la pièce isolante, pour relier la première et la deuxième face de la pièce sans passer par une arête de la pièce.

La pièce isolante de céramique peut également être réalisée selon la technologie des circuits hybrides couche épaisse, les pistes conductrices étant dans ce cas réalisées par sérigraphie d'encre conductrice.

La présente invention prévoit également un capteur du type décrit ci-dessus, comportant au moins un deuxième détecteur de la grandeur physique.

Selon un premier mode de réalisation, on monte le deuxième détecteur au moyen d'une deuxième pièce isolante, fixée à l'un des emplacements décrits ci-dessus. On peut ainsi réaliser un capteur à deux axes de sensibilité, à trois axes ..., dans un seul et même boîtier.

Selon un second mode de réalisation, on monte le deuxième détecteur sur une quatrième face de la pièce isolante comportant le premier détecteur. Il faut dans ce cas prévoir des pistes conductrices s'étendant depuis cette quatrième face jusqu'à la troisième face parallèle à la carte.

Ces objets, caractéristiques et avantages ainsi que d'autres de la présente invention seront exposés plus en détail dans la description suivante de modes de réalisations particuliers, dans laquelle on se limitera, pour des raisons de simplicité, à la réalisation d'un accéléromètre, faite en relation avec les figures jointes parmi lesquelles :
- les figures 1 et 2 destinées à illustrer l'état de la technique ont été décrites précédemment,
- la figure 3a est une vue de dessus d'un accéléromètre selon la présente invention,
- la figure 3b est une vue en coupe longitudinale de l'accéléromètre de la figure 3a,
- les figures 4a, 4b sont des vues détaillées d'un élément de l'accéléromètre des figures 3a et 3b,
- la figure 5 est une vue en coupe d'une partie de l'élément des figures 4a et 4b,
- la figure 6 représente un système de détection triaxial selon la présente invention, et
- la figure 7 illustre une variante de réalisation de la présente invention.

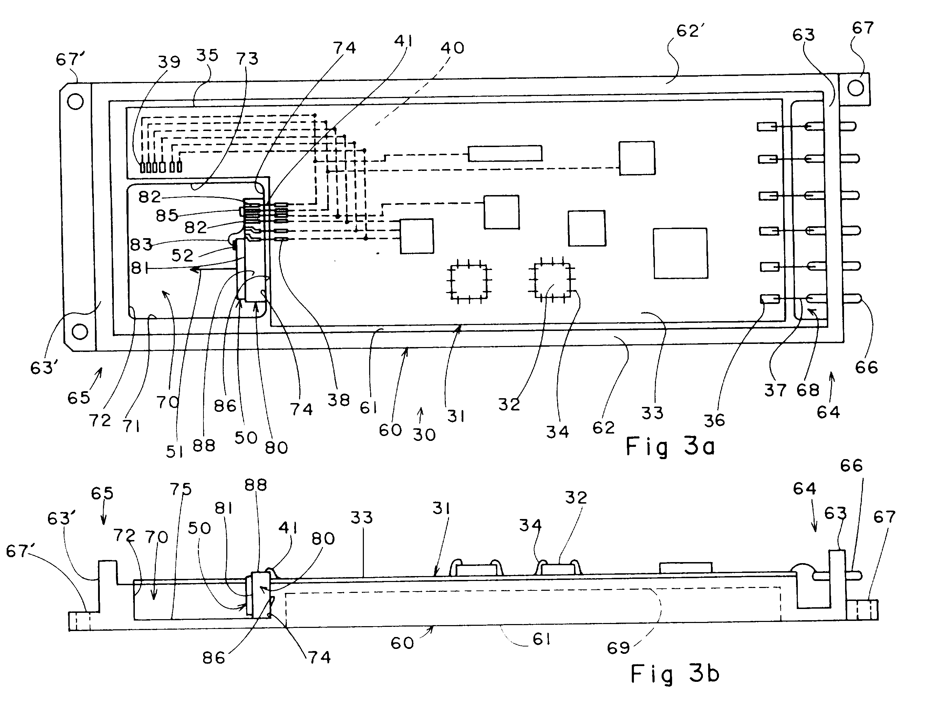

Les figures 3a et 3b représentent un accéléromètre intégré 30, conforme à la présente invention.

L'accéléromètre 30 comprend, de façon classique, un circuit électronique 31 associé à un détecteur d'accélération 50, l'ensemble étant disposé dans un boîtier électronique de protection 60, destiné à recevoir un capot, de manière à définir une enceinte étanche.

Le boîtier 60, ici de forme rectangulaire, comprend une plaque de fond 61 de forte épaisseur et des parois latérales longitudinales 62,62' et transversales 63,63'. A une extrémité 64 du boîtier on trouve des broches de connexion 66, traversant la paroi 63. Des pattes de fixation 67,67' formées aux extrémités respectives 64,65 du boîtier par des prolongements de la plaque de fond 61, permettent de fixer le boîtier sur un support. Dans un coin du boîtier 60, à proximité des parois 62 et 63', on trouve une cavité 70, ici de section carrée, pratiquée dans la plaque de fond 61. La cavité 70, pratiquée ici perpendiculairement à la plaque de fond 61 et parallèlement aux bords du boîtier, laisse apparaître quatre parois 71,72,73,74 formant les bords de la cavité, et une paroi 75 formant le fond de la cavité. Les parois 71,72,73,74 sont orthogonales deux à deux, la paroi 75 étant parallèle à la plaque de fond 61. A l'extrémité 64 du boîtier, une deuxième cavité 68 est pratiquée transversalement à la plaque de fond 61 pour permettre le passage des broches de connexion 66 dans le boîtier. Afin d'amincir la plaque de fond 61 et diminuer la masse du boîtier 60, on peut pratiquer un évidement 69 au dos du boîtier (représenté en pointillé sur la figure 3b), de manière que l'épaisseur moyenne de la plaque de fond 61 soit comparable à celle d'un boîtier classique.

Le circuit 31, fixé sur la plaque de fond 61, est formé de composants électroniques 32 montés sur un support d'interconnexion 33. Les composants 32 sont montés et électriquement reliés au support d'interconnexion 33 de façon classique, par exemple par collage et câblage par fils 34. Le circuit 31 peut être de tout type connu, notamment un circuit hybride ou un circuit imprimé. Les composants 32 peuvent être des composants discrets ou des circuits intégrés. Le support d'interconnexion 33 s'étend ici sur toute la surface disponible de la plaque de fond 61, depuis le bord de la cavité 68 jusqu'à la paroi transversale 63' de l'extrémité 65. Il comporte à cet effet un prolongement de moindre largeur 35, passant entre la paroi 73 de la cavité 70 et la paroi longitudinale 62' du boîtier. Le circuit 31 est connecté aux broches 66, au moyen de fils de connexion 37 reliant les broches 66 à des plages conductrices 36 du support d'interconnexion 33.

Le support d'interconnexion 33 comprend en outre une première rangée de contacts 38, ici au nombre de six, disposés le long de la paroi 74 de la cavité 70, et une deuxième rangée de six contacts 39 disposés le long de la paroi 73 de la cavité 70, sur le prolongement de moindre largeur 35. Les contacts 38 et 39 de même rang sont reliées à un même potentiel électrique, comme illustré schématiquement sur la figure 3a par des liaisons électriques 40 tracées en pointillés, menant à divers composants 32 du circuit 31.

Le détecteur 50 est un détecteur d'accélération classique fabriqué par gravure d'un matériau cristallin tel que le quartz ou le silicium, et prend la forme d'une microplaquette pourvue de plots de connexion métallisés, ici quatre plots 52. Le détecteur 50 est monoaxial et présente un axe de détection 51 perpendiculaire à son plan de pose. Pour ne pas sortir du cadre de la présente invention, on ne décrira pas ici la structure du détecteur 50 ni la fonctionnalité du circuit électronique 31, qui font partie de l'état de la technique. On se référera à titre d'exemple à l'article O. LEFORT "A Miniature Low Cost Silicon Micromachined Servo Accelerometer", Symposium Gyro Technology, 1988, Stuttgart, Germany, Edition H. SORG; ce document décrit diverses structures de détecteurs, et les circuits électroniques qui y sont associés.

Selon la présente invention, le détecteur 50 est monté sur une pièce isolante 80 permettant d'orienter de façon choisie le détecteur 50 dans le boîtier 60, mais permettant également de connecter le détecteur 50 au circuit électronique 31 par câblage ultrasonique.

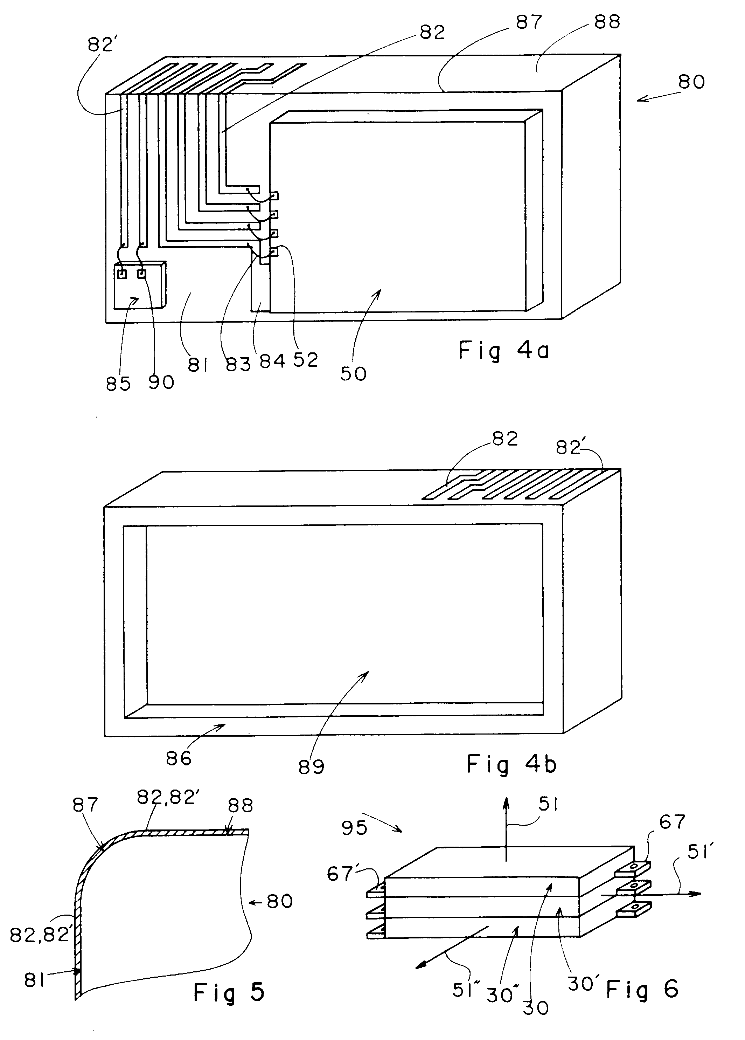

Dans cet exemple de réalisation de la présente invention, la pièce isolante est une pièce de céramique 80 parallélépipédique et rectangulaire présentant une épaisseur de quelques millimètres et une surface de quelques dizaines de millimètres carrés. La pièce de céramique 80 est représentée en détail sur les figures 4a et 4b, respectivement en vue avant et en vue arrière. Elle comporte une face avant 81 sur laquelle est reporté le détecteur 50, et une face arrière 86 fixée par collage dans le boîtier 60, d'une façon décrite ci-après. Des pistes conductrices 82,82', ici quatre pistes 82 et deux pistes 82', s'étendent sur la face avant 81 et se prolongent sur une tranche longitudinale 88 de la pièce 80, en passant sur une arête 87 formant l'intersection de la face avant 81 et de la tranche 88. Sur la face avant 81, les pistes 82 sont agencées de manière à venir en regard des plots 52 de la cellule 50, et sont reliées à ceux-ci par des fils 83 soudés par ultrasons. Les pistes 82' sont reliées de la même manière aux plots 90 d'un circuit intégré 85 de détection de température monté à proximité du détecteur 50. L'une des pistes 82 se prolonge en s'élargissant sous le détecteur 50, pour former une plage métallisée 84 de fixation du détecteur 50, celui-ci ayant ici une face arrière conductrice devant être reliée à un potentiel électrique. La face arrière 86 de la pièce de céramique 80 comporte un évidement 89, pratiqué par usinage, permettant de loger la colle de fixation de la pièce 80 afin de diminuer les défauts de parallélisme, dus aux surépaisseurs de colle entre la face arrière 88 et la surface de fixation.

On voit sur les figures 3a,3b que la face arrière 86 de la pièce de céramique 80 est fixée sur la paroi 74 de la cavité 70. Néanmoins, on peut également fixer la face arrière 86 sur la paroi 73, ou encore sur la paroi 75 formant le fond de la cavité 70, comme cela sera décrit plus loin.

On a en effet recherché ici la possibilité d'orienter l'axe de détection 51 du détecteur 50 des trois façons suivantes :
- selon un axe longitudinal au boîtier 60, et parallèle à la plaque de fond 61,
- selon un axe transversal, parallèle à la plaque de fond 61 et perpendiculaire à l'axe précédent,
- perpendiculairement à la plaque de fond 61 (orientation classique avec un détecteur de type transversal).

Dans l'accéléromètre 30 représenté sur les figures 3a,3b, l'axe de détection 51 est orienté de la première façon. La pièce 80 est collée contre la paroi 74 de la cavité 70, de sorte que le détecteur 50 se trouve agencé transversalement dans le boîtier 60, l'axe de détection 51 étant dans ces conditions orienté longitudinalement. Lorsque la pièce 80 est disposée de cette manière, la tranche 88 est parallèle au support d'interconnexion 33, et on s'arrange pour que les pistes 82,82' coïncident avec les contacts 38 du circuit 31. Chacune des pistes 82,82' peut être alors reliée au contact 38 correspondant par un fil 41 soudé par ultrasons, la connexion électrique étant ainsi établie entre le circuit 31 et le détecteur 50.

On voit donc que l'intérêt du système de l'invention est d'offrir une surface plane parallèle au support d'interconnexion 33, ici la tranche 88, sur laquelle on peut effectuer des opérations de câblage, notamment de câblage ultrasonique.

On remarquera que sur la figure 3b la pièce de céramique 80 dépasse sensiblement de la cavité 70. En effet la cavité 70 présente ici une profondeur de 4 mm, la pièce 80 présentant une hauteur de 6 mm, une longueur de 12 mm et une épaisseur de 2 mm. Il y a donc un décalage d'environ 2 mm entre le support 33 et la tranche 88 de la pièce de céramique (en négligeant l'épaisseur du support), ce qui ne constitue pas une gêne pour les opérations de câblage.

Outre l'agencement qui vient d'être décrit, et comme indiqué précédemment, on peut également choisir lors du montage de la pièce de céramique 80, de fixer celle-ci par sa face arrière 86 comme suit :
- contre la paroi 73, en connectant la pièce 80 aux contacts 39 du circuit 31. Dans ce cas, le détecteur 50 est agencé longitudinalement dans le boîtier 60, l'axe de détection 51 étant orienté transversalement.
- contre la paroi 75, c'est-à-dire à plat au fond de la cavité 70, le détecteur 50 étant alors parallèle à la plaque de fond 61. Dans cette dernière disposition, la face avant 81 est parallèle au support d'interconnexion 33 du circuit, et c'est donc à partir de la face avant 81 que l'on câble la pièce de céramique 80 au support 33. On peut connecter les pistes 82,82' de la face avant 81 aux contacts 38 de la carte, en accolant la tranche 88 à la paroi 74, ou les connecter aux contacts 39, en accolant la tranche 88 à la paroi 73.

La présente invention permet donc de réaliser un accéléromètre modulaire, offrant avantageusement plusieurs possibilités d'orientations du détecteur.

Elle permet également de résoudre tous les problèmes classiques liés à l'orientation du boîtier, qui nécessitaient parfois la réalisation de supports spéciaux. Ainsi, on peut réaliser simplement un système de détection triaxial 95 de faible encombrement, comme illustré par la figure 6, en empilant trois accéléromètres 30,30',30" ayant des axes de détection 51,51',51'' complémentaires.

On décrira maintenant, en relation avec les figures 4a et 4b, une technologie de fabrication de la pièce de céramique 80.

Dans l'exemple décrit précédemment, les pistes conductrices 82,82' sont obtenues au moyen d'une technique de sérigraphie d'encres conductrices, utilisée pour la fabrication des circuits hybrides dits "couche épaisse". La sérigraphie des pistes 82,82' s'effectue en deux étapes, l'une pour le dépôt des pistes 82,82' sur la face avant 81, l'autre pour le dépôt des pistes 82,82' sur la tranche 88. La pièce de céramique 80 est obtenue à partir d'un substrat standard de céramique Al₂O₃ découpé, usiné et rectifié. La continuité électrique des pistes 82,82' aux passages de l'arête 87 peut être obtenue en rajoutant manuellement de l'encre conductrice, bien qu'il soit plus avantageux de procéder en émoussant préalablement l'arête 87 sur une profondeur de quelques dizaines de microns, comme illustré par la figure 5. Dans ce cas, les différents tronçons de pistes 82,82' se recouvrent sur l'arête 87, qui constitue une zone de recouvrement commune.

Il apparaîtra clairement à l'homme de l'art que la présente invention n'est pas limitée à cette technologie particulière. On peut également utiliser la technologie dite des couches minces, la technologie des circuits hybrides dits cofrittés, la technologie du silicium ...

Selon la technologie des couches minces, les pistes 82,82' sont obtenues par évaporation sous vide d'une substance métallique, par exemple de l'aluminium, la pièce 80 étant préalablement recouverte d'un masque mécanique ou chimique (résine).

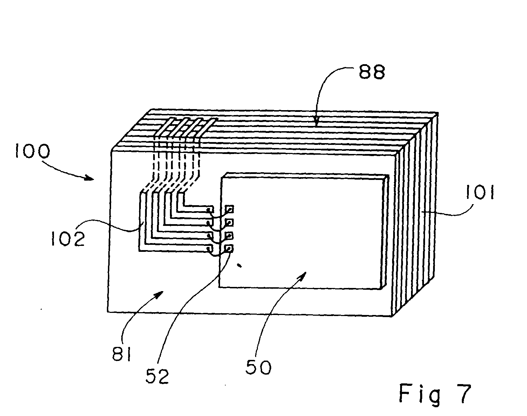

On a représenté sur la figure 7 une vue simplifiée d'une pièce de céramique 100 réalisée selon la technologie des circuits cofrittés. La pièce 100 est constituée d'un empilement de feuilles de céramique 101 formant après cuisson à haute température un ensemble compact. Avec cette technologie, on peut réaliser des pistes conductrices dans l'intérieur même de la structure de céramique. Ainsi, des pistes conductrices 102 passant dans l'intérieur de la pièce 100 (les passages sont représentés en traits pointillés), relient la tranche 88 de la pièce 100, à sa face avant 81. On remarquera que les pistes 102 se prolongent suffisamment sur la face avant 81 pour permettre la connexion de la pièce 100 à partir de cette face.

L'homme de l'art notera également que la présente invention est susceptible de diverses variantes et modifications et d'applications diverses. On peut appliquer la présente invention à la réalisation d'un accéléromètre triaxial, en agençant sur les différentes parois d'un même boîtier trois pièces isolantes supportant chacune un détecteur. Il est à la portée de l'homme de l'art d'adapter de façon simple la forme et la dimension des parois, et la disposition des parois relativement au circuit, pour permettre le montage et la connexion des trois détecteurs. Par ailleurs, la pièce isolante peut servir de support à plusieurs détecteurs, et peut revêtir des formes plus ou moins complexes en fonction du besoin.

Enfin, l'invention peut être appliquée à tout autre type de capteur comportant un détecteur miniaturisé en forme de microplaquette, sensible à une grandeur physique selon un axe déterminé.

## Revendications

1. Capteur (30) d'une grandeur physique orientée, comprenant un détecteur en forme de microplaquette (50) sensible à ladite grandeur physique selon un axe déterminé, et une carte (33) portant des composants électroniques (32) , contenus dans un boîtier (60) caractérisé en ce que :
- la microplaquette (50) est montée sur une première face (81) d'une pièce isolante (80,100) comportant une deuxième face (86) fixée au boîtier (60) et une troisième face (88) s'étendant parallèlement au plan de la carte (33),
- des pistes conductrices (82,102) s'étendent à partir de la première face (81), où elles sont reliées aux contacts (52) de la microplaquette (50), et se prolongent sur la troisième face (88), et
- la carte (33) comprend des contacts (38,39), disposés sensiblement en regard des prolongements des pistes conductrices (82,102) sur la troisième face (88).

2. Capteur selon la revendication 1, caractérisé en ce qu'il comporte plusieurs emplacements (73,74,75) de fixation de la pièce isolante (80,100), la carte (33) comprenant des contacts (38,39) disposés à proximité de chaque emplacement, en regard desdits prolongements des pistes conductrices (82,102) quand la pièce isolante (80,100) est montée sur l'un de ces emplacements.

3. Capteur selon la revendication 1, caractérisé en ce que la pièce isolante (80,100) est fixée sur une paroi (73,74,75) du boîtier (60) une partie au moins de ladite paroi s'étendant en dessous du plan de la carte (33), une partie de ladite deuxième face (86) s'étendant éventuellement au delà de ladite paroi (73,74,75).

4. Capteur selon la revendication 3, caractérisé en ce que le boîtier (60) comprend plusieurs parois (73,74,75) d'orientations différentes, la carte (33), comprenant des contacts (38,39) disposés au bord de chacune desdites parois (73,74,75), en regard desdits prolongements des pistes conductrices (82,102) quand la pièce isolante (80,100) est montée sur l'une de ces parois.

5. Capteur selon la revendication 4, caractérisé en ce que lesdites parois (73,74,75) sont des parois d'une cavité (70) s'étendant dans une zone du boîtier (60).

6. Capteur selon la revendication 5, caractérisé en ce que ladite cavité est un évidement (70) pratiqué dans la plaque de fond (61) du boîtier (60).

7. Capteur selon l'une des revendications 5 ou 6, caractérisé en ce que ladite cavité (70) est parallélépipédique.

8. Capteur selon l'une des revendications 3 à 7, caractérisé en ce que la pièce isolante (80,100) est de forme parallélépipédique, ladite première face (81), sur laquelle est montée la microplaquette (50), étant choisie parallèle à ladite deuxième face (86), fixée au boîtier (60).

9. Capteur selon l'une des revendications 1 à 8, caractérisé en ce qu'il comprend au moins un deuxième détecteur de ladite grandeur physique.

10. Capteur selon la revendication 9, caractérisé en ce que le deuxième détecteur est monté sur une quatrième face de ladite pièce isolante, la quatrième face comprenant des pistes conductrices se prolongeant jusqu'à ladite troisième face.

11. Capteur selon la revendication 9, caractérisé en ce que le deuxième détecteur est monté sur une deuxième pièce isolante.

12. Capteur selon l'une des revendications 1 à 9, caractérisé en ce que la pièce isolante (80,100) est en céramique.

13. Capteur selon la revendication 12, caractérisé en ce que la pièce isolante (100) est réalisée selon la technologie des circuits cofrittés, lesdites pistes conductrices (102) s'étendant en partie dans l'intérieur de la pièce isolante (100).

14. Capteur selon la revendication 12, caractérisé en ce que la pièce isolante (80) est réalisée selon la technologie des circuits hybrides couche épaisse, les pistes conductrices (82) étant réalisées par sérigraphie d'encre conductrice.

15. Capteur selon l'une des revendications précédentes, dans lequel le détecteur est un détecteur d'accélération.

16. Capteur selon l'une des revendications précédentes, dans lequel le détecteur est un détecteur de champ magnétique.

17. Système de détection d'une grandeur physique orientée, comprenant au moins deux capteurs (30,30',30'') selon l'une des revendications 1 à 8, caractérisé en ce que les capteurs sont empilés et présentent des axes de détection complémentaires (51,51',51'').

## Patentansprüche

1. Aufnehmer bzw. Meßwertgeber (30) für eine gerichtete physikalische Größe, welcher einen auf die genannte physikalische Größe längs einer vorgegebenen Achse ansprechenden Detektor in Mikroplättchenform (50) und eine elektronische Bauteile (32) tragende Karte (33) in einem Gehäuse (60) umfaßt,
dadurch gekennzeichnet, daß
- die Mikroplakette (50) auf einer ersten Oberfläche (81) eines Isolierteils (80, 100) angebracht ist, das eine am Gehäuse (60) befestigte zweite Oberfläche (86) und eine sich parallel zur Ebene der Karte (33) erstreckende dritte Oberfläche (88) aufweist,
- Leiterbahnen (82, 102) sich von der ersten Oberfläche (81), wo sie mit den Kontakten (52) der Mikroplakette (50) verbunden sind, erstrecken und sich auf die dritte Oberfläche (88) fortsetzen, sowie
- die Karte (33) Kontakte (38, 39) aufweist, die im wesentlichen in Ausrichtung bezüglich der Verlängerungen der Leiterbahnen (82, 102) auf der dritten Oberfläche (88) angeordnet sind.

2. Aufnehmer nach Anspruch 1,
dadurch gekennzeichnet, daß er mehrere Bereiche bzw. Stellen (73, 74, 75) für die Befestigung des Isolierteils (80, 100) aufweist, und daß die Karte (33) Kontakte (38, 39) aufweist, die benachbart jeder Befestigungsstelle angeordnet sind in Ausrichtung mit den genannten Verlängerungen der Leiterbahnen (82, 102), wenn das Isolierteil (80, 100) an einer seiner Befestigungsstellen montiert ist.

3. Aufnehmer nach Anspruch 1,
dadurch gekennzeichnet, daß das Isolierteil (80, 100) an einer Wandung (73, 74, 75) des Gehäuses (60) befestigt ist, wobei wenigstens ein Teil der genannten Wandung sich unter die Ebene der Karte (33) erstreckt, und daß ein Teil der genannten zweiten Oberfläche (86) sich gegebenenfalls über die genannte Wandung (73, 74, 75) erstreckt.

4. Aufnehmer nach Anspruch 3,
dadurch gekennzeichnet, daß das Gehäuse (60) mehrere Wandungen (73, 74, 75) unterschiedlicher Orientierung umfaßt, daß die Karte (33) Kontakte (38, 39) aufweist, die entlang jeder der genannten Wandungen (73, 74, 75) angeordnet sind in Ausrichtung mit den genannten Verlängerungen der Leiterbahnen (82, 102), wenn das Isolierteil (80, 100) an einer der genannten Wandungen montiert ist.

5. Aufnehmer nach Anspruch 4,
dadurch gekennzeichnet, daß die genannten Wandungen (73, 74, 75) Wandungen einer sich in einer Zone des Gehäuses (60) erstreckenden Vertiefung bzw. Mulde (70) sind.

6. Aufnehmer nach Anspruch 5,
dadurch gekennzeichnet, daß die genannte Vertiefung bzw. Mulde eine in der Bodenplatte (61) des Gehäuses (60) vorgesehene Ausnehmung bzw. Vertiefung (70) ist.

7. Aufnehmer nach einem der Ansprüche 5 oder 6,
dadurch gekennzeichnet, daß die genannte Vertiefung bzw. Mulde (70) parallelepipedisch ist.

8. Aufnehmer nach einem der Ansprüche 3 bis 7,
dadurch gekennzeichnet, daß das Isolierteil (80, 100) parallelepipedische Form besitzt, und daß die genannte erste Oberfläche (81), auf welcher die Mikroplakette (50) montiert ist, parallel zu der genannten zweiten, an dem Gehäuse (60) befestigten Oberfläche (86) gewählt ist.

9. Aufnehmer nach einem der Ansprüche 1 bis 8,
dadurch gekennzeichnet, daß er wenigstens einen zweiten Detektor für die genannte physikalische Größe umfaßt.

10. Aufnehmer nach Anspruch 9,
dadurch gekennzeichnet, daß der zweite Detektor auf einer vierten Oberfläche des genannten Isolierteils angebracht ist, wobei die vierte Oberfläche Leiterbahnen aufweist, welche sich bis zur dritten Oberfläche erstrecken.

11. Aufnehmer nach Anspruch 9,
dadurch gekennzeichnet, daß der zweite Detektor auf einem zweiten Isolierteil angeordnet ist.

12. Aufnehmer nach einem der Ansprüche 1 bis 9,
dadurch gekennzeichnet, daß das Isolierteil (80, 100) aus Keramik besteht.

13. Aufnehmer nach Anspruch 12,
dadurch gekennzeichnet, daß das Isolierteil (100) in Sinterschaltungstechnik hergestellt ist, und daß die genannten Leiterbahnen (102) sich teilweise ins Innere des Isolierteils (100) erstrecken.

14. Aufnehmer nach Anspruch 12,
dadurch gekennzeichnet, daß das Isolierteil (80) in Dickschicht-Hybridschaltungstechnik ausgeführt ist, und daß die Leiterbahnen (82) durch Bedrucken mit Leiterpaste im Siebdruckverfahren hergestellt sind.

15. Aufnehmer nach einem der vorhergehenden Ansprüche,
wobei der Detektor ein Beschleunigungsdetektor ist.

16. Aufnehmer nach einem der vorhergehenden Ansprüche,
wobei der Detektor ein Magnetfelddetektor ist.

17. System zum Nachweis einer gerichteten physikalischen Größe, welches wenigstens zwei Aufnehmer (30, 30', 30") nach einem der Ansprüche 1 bis 8 aufweist,
dadurch gekennzeichnet, daß die Aufnehmer übereinandergestapelt sind und zueinander komplementäre Detektionsachsen (51, 51', 51") aufweisen.

## Claims

1. A detector (30) for detecting an oriented physical variable including, in a casing (60), a chip-shaped sensor (50) sensitive to said physical variable according to a predetermined axis, and a board (33, 205) bearing electronic components (32), characterized in that:
- the chip (50) is mounted on a first surface (81) of an insulating part (80, 100) that includes a second surface (86) fastened to said casing (60) and a third surface (88) that extends parallel with the plane of the board (33),
- conductive paths (82, 102) extend from the first surface (81), where they are connected to contacts (52) of said chip (50), and overlap said third surface (88), and
- the board (33) includes contacts (38, 39) that are disposed so as to substantially face the extensions of said conductive paths (82, 102) on said third surface (88).

2. The detector of claim 1, characterized in that it includes a plurality of locations (73, 74, 75) for fastening the insulating part (80, 100), the board (33) including contacts (38, 39) that are disposed in the vicinity of each fastening location, facing said extensions of conductive paths (82, 102) when the insulating part (80, 100) is mounted on one of said fastening locations.

3. The detector of claim 1, characterized in that the insulating part (80, 100) is fastened to a wall (73, 74, 75) of said casing (60), one portion at least of said wall extending below the plane of the board (33), a portion of said second surface (86) possibly extending beyond said wall (73, 74, 75).

4. The detector of claim 3, characterized in that said casing (60) includes a plurality of differently oriented walls (73, 74, 75), the board (33) including contacts (38, 39) disposed on the edge of each wall (73, 74, 75), facing said extensions of the conductive paths (82, 102) when the insulating part (80, 100) is mounted on one of said walls.

5. The detector of claim 4, characterized in that said walls (73, 74, 75) have a cavity (70) extending in a portion of said casing (60).

6. The detector of claim 5, characterized in that said cavity is a recess (70) made in the bottom plate (61) of the casing (60).

7. The detector of claim 5 or 6, characterized in that said recess (70) is parallelepipedic.

8. The detector of any of claims 3 to 7, characterized in that the insulating part (80, 100) is parallelepipedic, said first surface (81), on which the chip (50) is mounted, being chosen to be parallel with said second surface (86) that is fastened to said casing (60).

9. The detector of any of claims 1 to 8, characterized in that it includes at least a second sensor for detecting said physical variable.

10. The detector of claim 9, characterized in that the second sensor is mounted on a fourth surface of said insulating part (80, 100), the fourth surface including conductive paths (82, 102) extending up to said third surface.

11. The detector of claim 9, characterized in that said second sensor is mounted on a second insulating part.

12. The detector of any of claims 1 to 9, characterized in that said insulating part (80, 100) is made of ceramic.

13. The detector of claim 12, characterized in that said insulating part (100) is fabricated according to co-sintered circuit technology, said conductive paths (102) partially extending inside said insulating part (100).

14. The detector of claim 12, characterized in that said insulating part (80) is fabricated according to thick-film technology, the conductive paths (82) being carried out by conductive ink serigraphy.

15. The detector of any of the former claims, characterized in that the sensor is an acceleration sensor.

16. The detector of any of the former claims, characterized in that the sensor is a magnetic field detector.

17. A system for detecting an oriented physical variable, comprising at least two sensors (30, 30', 30") according to any of claims 1 to 8, characterized in that the sensors are piled up and have complementary detection axes (51, 51', 51").
